# EUROPÄISCHE PATENTSCHRIFT

(11) **EP 3 715 881 B1**
(45) Veröffentlichungstag und Bekanntmachung des Hinweises auf die Patenterteilung: **17.05.2023**
(21) Anmeldenummer: 19165667.7
(22) Anmeldetag: 28.03.2019
(51) Int. Cl.: G01R 31/12, H01B 17/00

(54) **VERFAHREN ZUR INSTANDHALTUNG EINER HOCHSPANNUNGSDURCHFÜHRUNG**
METHOD FOR MAINTENANCE OF A HIGH-VOLTAGE BUSHING
PROCÉDÉ D'ENTRETIEN D'UNE TRAVERSÉE À HAUTE TENSION

(43) Veröffentlichungstag der Anmeldung: 30.09.2020
(73) Patentinhaber: Siemens Energy Global GmbH & Co. KG, 81739 München (DE)
(72) Erfinder: Cebulla, Christof, 14199 Berlin (DE); Langens, Achim, 53797 Lohmar (DE)

(56) Entgegenhaltungen:
- US-A1- 2013 107 410
- US-A1- 2014 368 215
- US-A1- 2016 202 303
- US-A1- 2017 227 592
- US-B1- 6 177 803

## Beschreibung

Die Erfindung betrifft ein Verfahren zum Instandhalten einer Hochspannungsdurchführung. Im Allgemeinen hat eine Hochspannungsdurchführung die Aufgabe, eine sich auf Hochspannungspotential (üblicherweise oberhalb von 1 kV) befindende Hochspannungsleitung mit einem stromführenden Stromleiter von einer sich im Wesentlichen auf Erdpotential befindenden Umgebung zu isolieren, beispielsweise einer Wandung (Gehäusewandung) eines Transformators. Ein Innenleiter der Hochspannungsdurchführung bildet dabei einen Teil des Stromleiters aus bzw. ist in diesen eingefügt und ist zugleich von einem Isolierkörper umgeben bzw. ist durch einen solchen hindurchgeführt.

Eine solche Hochspannungsdurchführung ist beispielsweise aus der WO 2017/152985 A1 bekannt.

Bisher war der Betrieb der Hochspannungsdurchführung stets mit einer Planung der Reparaturarbeiten und Wartung der Hochspannungsdurchführung durch einen Service-Mitarbeiter vor Ort verbunden. Eine Zustandsermittlung war oft nur in Betriebspausen der Hochspannungsdurchführung möglich.

Ein Verfahren zum Überwachen einer Gruppe von Durchführungen, bei dem Durchführungsströme miteinander verglichen werden, ist aus der US 6177803 B1 bekannt. Ein weiteres System zur Überwachung von Durchführungen ist in der US 2017/0227592 A1 beschrieben. Ein Verfahren zum Messen eines Verlustfaktors eines Isolators ist in der US 2013/0107410 A1 offenbart. Die US 2016/0202303 A1 beschreibt ein weiteres Monitoring-System für Durchführungen. Aus der US 2014/0368215 A1 ist ein sicheres Verfahren zur Überprüfung eines Zustandes einer Hochspannungsdurchführung offenbart.

Die Aufgabe der Erfindung ist es, ein Verfahren zum Instandhalten der Hochspannungsdurchführung anzugeben, das möglichst einfach ist und einen möglichst zuverlässigen Betrieb der Hochspannungsdurchführung ermöglicht.

Die Aufgabe wird erfindungsgemäß durch ein Verfahren gemäß unabhängigem Anspruch 1 gelöst, bei dem an der Hochspannungsdurchführung gemessene Messwerte oder davon abgeleitete Größen als Sensordaten in Form wenigstens einer Zeitreihe, geeigneterweise in einem Datenspeicher einer Datenverarbeitungseinrichtung, gespeichert werden, die wenigstens eine Zeitreihe auf das Vorhandensein eines vorgegebenen Vorfehlermusters untersucht wird und bei Vorhandensein des Vorfehlermusters eine Wartungsanweisung zum Durchführen einer Steuerungs- und/oder Wartungsmaßnahme an der Hochspannungsdurchführung ausgelöst wird. Demnach wird das Verfahren zum Instandhalten der Durchführung nicht mehr am Ort der installierten Hochspannungsdurchführung, sondern zumindest zum Teil ferngesteuert und rechnerunterstützt durchgeführt. Geeigneterweise ist die Hochspannungsdurchführung mit wenigstens einer Sensoreinrichtung ausgestattet, die entsprechende Messwerte liefert, vorzugsweise kontinuierlich in der Zeit, beispielsweise gemäß einer vorgegebenen Messrate (die Messwerte werden demnach sukzessive gemäß der Messrate erfasst). Die Messdaten bzw. Messwerte können vorverarbeitet werden, so dass davon abgeleitete Werte (zum Beispiel zeitliche Absolutwerte, Mittelwerte oder dergleichen) bereitgestellt sind. Möglich ist ebenfalls, dass transiente Vorgänge, wie beispielsweise Änderungen von Messwerten, als Sensordaten gespeichert werden. Die Sensordaten können bevorzugt per Funk also Kabellos (zum Beispiel unter Verwendung einer Mobilfunktechnik) der Datenverarbeitungseinrichtung zur Verfügung gestellt werden. Dabei verfügt die Datenverarbeitungseinrichtung geeigneterweise über eine Schnittstelle, die ein sukzessives Empfangen der Sensordaten ermöglicht. Die Sensordaten werden entsprechend kontinuierlich gespeichert, so dass wenigstens eine entsprechende Zeitreihe entsteht. Messdaten unterschiedlicher Arten, beispielsweise Spannungsdaten und Temperaturdaten, können in mehreren unterschiedlichen Zeitreihen gespeichert werden. Die gespeicherten Zeitreihen können im Rahmen der Erfindung mittels zeitreihenanalytischer Verfahren untersucht werden. Dabei wird die Zeitreihe auf das Vorhandensein oder Vorliegen eines vorgegebenen Musters untersucht, das auf einen Zustand der Hochspannungsdurchführung schließen lässt, der zeitlich einem Fehlerzustand vorausgeht. Dies kann zum Beispiel durchgeführt werden, indem eine Teilfolge der Zeitreihe mit einer vorgegebenen Muster-Datenfolge verglichen wird. Eine andere Möglichkeit ist, die Teilfolge auf eine oder mehrere vorher festgelegte Bedingungen zu überprüfen. Das vorbestimmte Muster (bzw. Muster-Datenfolge) kann beispielsweise ein bestimmter Anstieg der Zeitreihenwerte oder das Überschreiten eines vorgegebenen Schwellenwertes sein. Es sind jedoch für manche Anwendungen auch komplexe Muster denkbar, wie Korrelationsmuster, insbesondere Autokorrelationsmuster, bestimmte Werteabfolgen oder auch statistische Verteilungen von Zeitreihenwerten, inklusive zeitlich gefensterter Mittelwerte (moving average) und dergleichen. Die Vorhersage des Wartungsbedarfes unterliegt im Rahmen der Erfindung keinen zeitlichen Vorgaben. Somit kann das Vorfehlermuster einen bereits beginnenden Wartungsbedarf bzw. eine Fehlfunktion oder eine Störung andeuten. Bestenfalls zeigt das Vorliegen eines Vorfehlermusters ein unerwünschtes Verhalten mit einem zeitlichen Vorlauf. Die durchzuführenden Wartungsmaßnahmen können zum Beispiel eine bloße Überprüfung des Zustandes der Hochspannungsdurchführung (auch anhand der Sensordaten) durch einen Wartungsarbeiter, ein Austausch von Bauteilen der Hochspannungsdurchführung oder auch eine Reinigung deren Komponenten sein. Ggf. kann auch der weitere Betrieb infolge der erhaltenen Erkenntnisse angepasst werden. Geeignete Steuerungsmaßnahmen sind beispielsweise Maßnahmen, die in einer Reduzierung des Stromes durch die Durchführung resultieren. Es ist denkbar, dass die Wartungsanweisung beispielsweise an ein mobiles Gerät gesendet wird, das sich im Besitz eines zur Wartung der Hochspannungsdurchführung Berechtigten befindet und zur Anzeige der Wartungsanweisung geeignet ist.

Ein wesentlicher Vorteil des erfindungsgemäßen Verfahrens ist, dass die Überwachung zur Instandhaltung der Hochspannungsdurchführung zeitkontinuierlich und automatisiert erfolgt. Dies bringt sowohl einen Kostenvorteil als auch eine Verbesserung im Sinne der Zuverlässigkeit. Der Betreiber der Hochspannungsdurchführung oder auch deren Hersteller können zudem vergleichbar schnell eine Information über den Zustand und ggf. über einen Wartungsbedarf der Hochspannungsdurchführung erhalten.

Vorzugsweise wird die Wartungsanweisung mittels eines optischen und/oder akustischen Auslösesignals ausgelöst. Mittels der Datenverarbeitungseinrichtung kann beispielsweise eine GUI (graphical user interface) bereitgestellt werden, die das Auslösesignal bereitstellt bzw. aktiviert. Mehrere unterschiedliche Auslösesignale sind denkbar, falls unterschiedliche Fehlerszenarien ausgewertet werden.

Vorzugsweise umfassen die Sensordaten Spannungsmessdaten, Strommessdaten und/oder Temperaturmessdaten oder abgeleitete Größen. Die Spannungsmessdaten können beispielsweise aus Spannungsmessungen an einem Spannungsteileranschluss stammen. Die Temperaturmessdaten können als Innenleitertemperaturmessdaten von Temperaturmessungen am Innenleiter der Hochspannungsdurchführung und/oder Temperaturmessungen einer Außentemperatur an der Hochspannungsdurchführung stammen. Die Strommessdaten umfassen Leckstrommessdaten aus Messungen eines an der Oberfläche eines Außengehäuses bzw. Isolatoroberfläche einer Außenisolation der Hochspannungsdurchführung fließenden Leckstromes. Aus einzelnen oder allen dieser Messdaten können zugeordnete Zeitreihen gebildet und untersucht werden. Das Vorfehlermuster umfasst dabei eine signifikante Abweichung der Leckstrommessdaten einer Hochspannungsdurchführung in Bezug auf den (räumlichen) Mittelwert mehrerer benachbart angeordneter Hochspannungsdurchführungen.

Gemäß einer Ausführungsform der Erfindung umfasst die Untersuchung auf das Vorhandensein eines Vorfehlermusters eine kombinierte Analyse mehrerer, unterschiedlichen Messwertarten zugeordneter Zeitreihen. Beispielsweise können eine Temperaturmessungszeitreihe und eine Spannungsmessungszeitreihe oder auch andere Zeitreihen kombiniert unter Berücksichtigung von Korrelationen analysiert werden. Eine kombinierte Analyse mehrerer Zeitreihen hat den Vorteil, dass auch Informationen gewonnen werden können, die nicht als direkte Messungen vorliegen. Beispielsweise können auch Messungen im Außenbereich der Hochspannungsdurchführung Hinweise auf den Zustand im Inneren der Hochspannungsdurchführung erlauben (wie beispielsweise Temperatur). Zur kombinierten Analyse können beispielsweise Methoden wie Neuronale Netze oder ähnliche verwendet werden. Das neuronale Netz kann darauf trainiert werden, ein vordefiniertes Vorfehlermuster in den Daten zu erkennen.

Gemäß einer weiteren Ausführungsform der Erfindung umfasst das Untersuchen der wenigstens einen Zeitreihe einen Vergleich der wenigstens einer Zeitreihe mit Sensordaten weiterer Hochspannungsdurchführungen. In manchen Anwendungen kann es erschwert sein, aus den Messdaten einer einzelnen Hochspannungsdurchführung auf ein Fehlverhalten dieser Hochspannungsdurchführung zu schließen. Eine Verbesserung der Vorhersagefähigkeit kann erreicht werden, wenn Sensordaten mehrerer Hochspannungsdurchführungen zur Untersuchung auf vorbestimmte Muster herangezogen werden. Beispielsweise können wenigstens zwei Sets von Zeitreihen von zwei unterschiedlichen Hochspannungsdurchführungen, die in einer und derselben Hochspannungsanlage verbaut sein können, aber nicht notwendigerweise müssen, in der Datenverarbeitungseinrichtung gespeichert werden. Diese beiden (oder mehr) Sets können einer kombinierten Untersuchung unterzogen werden. Dabei ist auch eine statistische Analyse möglich. Beispielsweise können bestimmte Auffälligkeiten in den Daten aus einer Hochspannungsdurchführung gegenüber den Daten der übrigen Hochspannungsdurchführungen (oder einem Mittelwert oder dergleichen) Informationen über einen Wartungsbedarf geben. Dieses Vorgehen ist sogar nicht auf Hochspannungsdurchführungen beschränkt. Beispielsweise können Sensordaten einer Hochspannungsdurchführung, die eine Transformatordurchführung ist, kombiniert mit Sensordaten des zugehörigen Transformators analysiert werden. Insbesondere kann das Vorfehlermuster bei einer statistisch signifikanten Abweichung von Zeitreihenwerten der wenigstens einen Zeitreihe von einem Zeitreihenwertemittelwert über mehrere Zeitreihen mehrerer weiterer Hochspannungsdurchführungen vorliegen. Vorteilhaft hierbei ist insbesondere, dass die Untersuchung nicht auf einer statisch vorgegebenen Schwelle bzw. Basiswert oder dergleichen basiert, sondern dynamisch auch allgemeine, sich langsam in der Zeit verändernde Umgebungsbedingungen berücksichtigen kann. Aus eigenen Untersuchungen ist bekannt, dass gleiche Muster in den Messdaten unterschiedliche Ursachen haben können. Beispielsweise kann bei Messung von Leck- bzw. Ableitströmen in der Durchführung eine Erhöhung solcher Ströme sowohl auf einen Fehler der Durchführung als auch auf eine bestimmte Umgebungsbedingung zurückgeführt werden, wie beispielsweise einen starken Regenfall. Durch einen Querabgleich der Sensordaten von mehreren Durchführungen können Fehlzuordnungen bzw. Fehlerkennungen von Mustern vermieden werden. Dazu können zum Beispiel statistische Auswertemethoden herangezogen werden.

Bevorzugt wird die wenigstens eine Zeitreihe auf das Vorhandensein mehrerer vorgegebener Vorfehlermuster untersucht, wobei jedem Vorfehlermuster eine eigene Wartungsmaßnahme bzw. Steuerungsmaßnahme und eine entsprechende Wartungsanweisung zugeordnet werden, wobei ferner jeder Wartungsanweisung ein eigenes Auslösesignal zugeordnet wird, und bei Vorhandensein eines bestimmten Vorfehlermusters das zugeordnete Auslösesignal erzeugt wird. Somit kann vorteilhaft eine differenzierte Instandhaltung erreicht werden, die unterschiedliche mögliche Fehlfunktionen und Störungen berücksichtigt und anzeigt.

Die Erfindung betrifft ferner eine Datenverarbeitungseinrichtung.

Datenverarbeitungseinrichtungen sind insbesondere als Rechner bereits aus dem Stand der Technik bekannt.

Die Aufgabe der Erfindung besteht darin, eine Datenverarbeitungseinrichtung anzugeben, die eine möglichst effektive und effiziente Instandhaltung von Hochspannungsdurchführungen ermöglicht.

Die Aufgabe wird erfindungsgemäß durch eine Datenverarbeitungseinrichtung, die zum Durchführen eines erfindungsgemäßen Verfahrens eingerichtet ist. Die Einrichtung der Datenverarbeitungseinrichtung erfolgt geeigneter Weise mittels eines entsprechenden Computerprogramms bzw. -codes, in dem die Anweisungen des Verfahrens kodiert sind. Die Datenverarbeitungseinrichtung verfügt zweckmäßigerweise über die erforderlichen Hardware-Komponenten zum Empfand der Sensordaten, zum Speichern der Daten und ggf. zur Anzeige von Auslösesignalen bzw. zum Auslösen der Wartungsmaßnahme und/oder der Steuerungsmaßnahme.

Die Datenverarbeitungseinrichtung, in der die Messdaten gespeichert werden, kann als eine physikalische Einheit ausgebildet sein. Sie kann jedoch auch, insbesondere der zugeordnete Speicher im Allgemeinen auch auf mehrere, voneinander beabstandete Komponenten verteilt sein, zum Beispiel in der sogenannten Cloud.

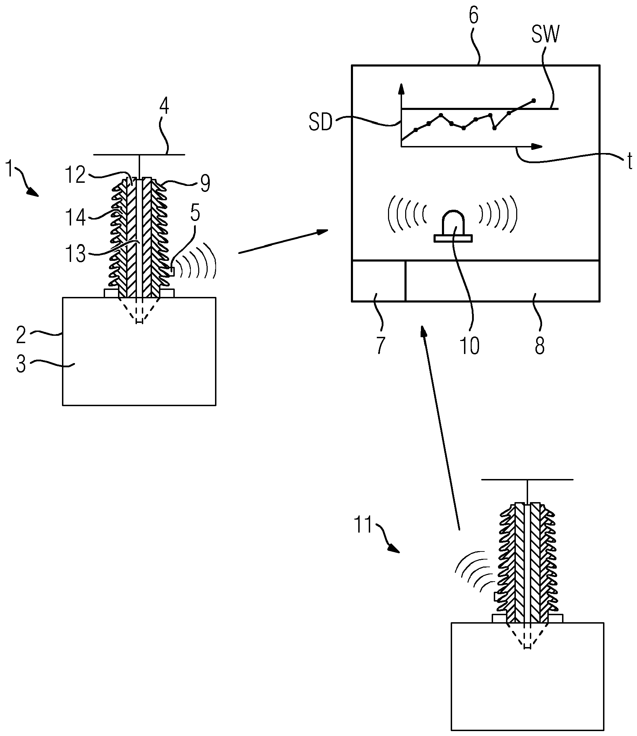

Die Erfindung wird nachfolgend anhand der Figur weiter erläutert.

Die Figur zeigt den Ablauf eines Ausführungsbeispiels des erfindungsgemäßen Verfahrens in einer schematischen Darstellung.

In der Figur ist eine Hochspannungsdurchführung 1 dargestellt, die in das Gehäuse 2 eines Transformators 3 eingesetzt ist. Die Hochspannungsdurchführung 1 dient zur isolierten Durchführung eines Leiters 13, der mit einer Wicklung des Transformators 3 verbunden ist, durch das Gehäuse 2 zur Verbindung mit einer Freileitung 4. Die Hochspannungsdurchführung umfasst eine Sensorvorrichtung 5, die zum Erfassen von Messdaten eingerichtet ist. Die Sensorvorrichtung 5 sendet die Messdaten per Funkt in Form von Sensordaten an einen geeigneten Empfänger.

Eine Datenverarbeitungseinrichtung 6 empfängt mittels einer Empfangseinrichtung 7 die Sensordaten. Die Sensordaten werden in einem Datenspeicher 8 gespeichert. Die Sensordaten werden in Form einer Zeitreihe gespeichert, wobei eine grafische Darstellung der Sensordaten erfolgen kann, und zwar in einem Diagramm, der Werte SD der Sensordaten in Abhängigkeit von der Zeit t anzeigt. Die Zeitreihe wird im dargestellten Beispiel auf das Vorhandensein eines Musters untersucht, wobei das vorgegebene Muster ein Vorfehlermuster ist, dass eine Überschreitung einer Schwelle SW durch die Sensordatenwerte umfasst.

Im gezeigten Beispiel sind die Sensordaten gemessene Leckstrommessdaten, die angeben, wie hoch ein Leckstrom über eine Isolatoroberfläche 14 eines äußeren Isolators 9 der Hochspannungsdurchführung 1 ist. Das Überschreiten der Schwelle SW wird als eine hohe Verschmutzung der Isolatoroberfläche 14 gedeutet, die wiederum eine Beeinträchtigung bzw. Fehlfunktion der Hochspannungsdurchführung bewirken kann. Entsprechend wird eine Wartungsmaßnahme ausgelöst, indem eine visuelle Anzeige 10 aktiviert wird.

Die Schwelle SW ist im figürlich dargestellten Beispiel nicht statisch, sondern wird unter Berücksichtigung von Sensordaten einer weiteren Hochspannungsdurchführung 11 festgelegt, die hierbei zur Hochspannungsdurchführung gleichartig aufgebaut ist. Auf diese Weise kann erreicht werden, dass die Festlegung der Schwelle SW lokale Umgebungsbedingungen berücksichtigt, falls die beiden Hochspannungsdurchführungen 1 und 11 räumlich nah beieinander angeordnet sind.

Weitere Beispiele für mögliche Vorfehlermuster sind:
Eine bestimmte Anzahl von Temperaturmesswerten liegt oberhalb eines vorbestimmten Temperaturgrenzwertes;
Ein signifikanter Spannungsabfall bezogen auf einen laufenden Mittelwert von Spannungsmesswerten;
Eine signifikante Abweichung von Leckstrom-Messwerten einer Hochspannungsdurchführung in Bezug auf den (räumlichen) Mittelwert mehrerer benachbart angeordneter Hochspannungsdurchführungen;
Der Korrelationskoeffizient eines Zeitreihenabschnitts und eines vorgegebenen (künstlichen) Zeitreihenverlaufes liegt oberhalb einer durch Kalibrierung festgelegten Schwelle.

## Patentansprüche

1. Verfahren zum Instandhalten einer Hochspannungsdurchführung (1), bei dem
- an der Hochspannungsdurchführung (1) gemessene Messwerte oder davon abgeleitete Größen als Sensordaten in Form wenigstens einer Zeitreihe gespeichert werden, wobei die Sensordaten Strommessdaten umfassen,
- die wenigstens eine Zeitreihe auf das Vorhandensein eines vorgegebenen Vorfehlermusters untersucht wird und
- bei Vorhandensein des Vorfehlermusters eine Wartungsanweisung zur Durchführung einer Steuerungs- und/oder Wartungsmaßnahme an der Hochspannungsdurchführung (1) ausgelöst wird,
**dadurch gekennzeichnet, dass**
die Strommessdaten Leckstrommessdaten eines über eine Isolatoroberfläche (14) der Hochspannungsdurchführung (1) fließenden Leckstromes umfassen, wobei das Vorfehlermuster eine signifikante Abweichung der Leckstrommessdaten in Bezug auf einen Leckstrom-Mittelwert mehrerer benachbart angeordneter Hochspannungsdurchführungen umfasst.

2. Verfahren nach Anspruch 1, wobei die Wartungsanweisung mittels eines optischen und/oder akustischen Auslösesignals ausgelöst wird.

3. Verfahren nach einem der vorangehenden Ansprüche, wobei die Sensordaten Spannungsmessdaten, Strommessdaten und/oder Temperaturmessdaten oder abgeleitete Größen umfassen.

4. Verfahren nach einem der vorangehenden Ansprüche, wobei die Temperaturmessdaten Innenleitertemperaturmessdaten eines Innenleiters (13) der Hochspannungsdurchführung (1) umfassen.

5. Verfahren nach einem der vorangehenden Ansprüche, wobei die Untersuchung auf Vorfehlermuster eine kombinierte Analyse mehrerer, unterschiedlichen Messwertarten zugeordneter Zeitreihen umfasst.

6. Verfahren nach einem der vorangehenden Ansprüche, wobei das Untersuchen der wenigstens einen Zeitreihe einen Vergleich der wenigstens einer Zeitreihe mit Sensordaten weiterer Hochspannungsdurchführungen (11) umfasst.

7. Verfahren nach Anspruch 6, wobei das Vorfehlermuster bei einer statistisch signifikanten Abweichung von Zeitreihenwerten der wenigstens einen Zeitreihe von einem Zeitreihenwertemittelwert über mehrere Zeitreihen mehrerer weiterer Hochspannungsdurchführungen vorliegt.

8. Verfahren nach einem der vorangehenden Ansprüche, wobei die wenigstens eine Zeitreihe auf das Vorhandensein mehrerer vorgegebener Vorfehlermuster untersucht wird, wobei jedem Vorfehlermuster eine eigene Wartungsanweisung zugeordnet wird, wobei ferner jeder Wartungsanweisung ein eigenes Auslösesignal zugeordnet wird, und bei Vorhandensein eines bestimmten Vorfehlermusters das zugeordnete Auslösesignal erzeugt wird.

9. Datenverarbeitungseinrichtung (6), die zum Durchführen des Verfahrens mach einem der Ansprüche 1 bis 8 eingerichtet ist.

## Claims

1. Method for maintaining a high-voltage bushing (1), in which
- measured values measured at the high-voltage bushing (1) or variables derived therefrom are stored as sensor data in the form of at least one time series, wherein the sensor data comprise current measurement data,
- the at least one time series is examined for the presence of a predetermined pre-fault pattern, and
- if the pre-fault pattern is present, a maintenance instruction for carrying out a control and/or maintenance measure on the high-voltage bushing (1) is triggered,
**characterized in that**
the current measurement data comprise leakage current measurement data of a leakage current flowing via an insulator surface (14) of the high-voltage bushing (1), wherein the pre-fault pattern comprises a significant deviation of the leakage current measurement data with respect to a leakage current average of a plurality of adjacently arranged high-voltage bushings.

2. Method according to Claim 1, wherein the maintenance instruction is triggered by means of a visual and/or acoustic trigger signal.

3. Method according to either of the preceding claims, wherein the sensor data comprise voltage measurement data, current measurement data and/or temperature measurement data or derived variables.

4. Method according to one of the preceding claims, wherein the temperature measurement data comprise inner conductor temperature measurement data of an inner conductor (13) of the high-voltage bushing (1).

5. Method according to one of the preceding claims, wherein the examination for pre-fault patterns comprises a combined analysis of a plurality of time series associated with different types of measured value.

6. Method according to one of the preceding claims, wherein the examination of the at least one time series comprises a comparison of the at least one time series with sensor data of further high-voltage bushings (11).

7. Method according to Claim 6, wherein the pre-fault pattern is present when there is a statistically significant deviation of time series values of the at least one time series from a time series value average over a plurality of time series of a plurality of further high-voltage bushings.

8. Method according to one of the preceding claims, wherein the at least one time series is examined for the presence of a plurality of predetermined pre-fault patterns, wherein a separate maintenance instruction is assigned to each pre-fault pattern, wherein a separate trigger signal is also assigned to each maintenance instruction, and the assigned trigger signal is generated if a certain pre-fault pattern is present.

9. Data processing device (6), which is configured to carry out the method according to one of Claims 1 to 8.

## Revendications

1. Procédé d'entretien d'une traversée (1) à haute tension, dans lequel
- on met en mémoire, comme données de capteur sous la forme d'au moins une série temporelle, des valeurs de mesure mesurées sur la traversée (1) à haute tension ou des grandeurs qui s'en déduisent,
- les données de capteur comprennent des données de mesure de courant,
- on recherche, sur la au moins une série temporelle, la présence d'un motif de pré-défaut donné à l'avance, et
- en présence du motif de pré-défaut, on déclenche une instruction d'entretien pour effectuer une mesure de commande et/ou d'entretien sur la traversée (1) à haute tension,
**caractérisé en ce que**
les données de mesure du courant comprennent des données de mesure de courant de fuite d'un courant de fuite passant par une surface (14) d'isolateur de la traversée (1) à haute tension, dans lequel le motif de pré-défaut comprend un écart significatif des données de mesure de courant de fuite, par rapport à une valeur moyenne de courant de fuite de plusieurs traversées à haute tension disposées au voisinage.

2. Procédé suivant la revendication 1, dans lequel on déclenche l'instruction d'entretien au moyen d'un signal de déclenchement optique et/ou acoustique.

3. Procédé suivant l'une des revendications précédentes, dans lequel les données de capteur comprennent des données de mesure de courant et/ou des données de mesure de température ou de grandeurs qui s'en déduisent.

4. Procédé suivant l'une des revendications précédentes, dans lequel les données de mesure de température comprennent des données de mesure de température d'un conducteur (13) intérieur de la traversée (1) à haute tension.

5. Procédé suivant l'une des revendications précédentes, dans lequel la recherche de motifs de pré-défaut comprend une analyse combinée de plusieurs séries temporelles associées à des types de valeurs de mesure différents.

6. Procédé suivant l'une des revendications précédentes, dans lequel la recherche sur la au moins une série temporelle comprend une comparaison de la au moins une série temporelle à des données de capteur d'autres traversées (11) à haute tension.

7. Procédé suivant la revendication 6, dans lequel le motif de pré-défaut est présent s'il y a un écart significatif statistiquement de valeurs de série temporelle de la au moins une série temporelle à une valeur moyenne de série temporelle sur plusieurs séries temporelles de plusieurs traversées à haute tension.

8. Procédé suivant l'une des revendications précédentes, dans lequel on utilise, sur la au moins une série temporelle, la présence de plusieurs motifs de pré-défaut donnés à l'avance, dans lequel on associe à chaque motif de pré-défaut sa propre instruction d'entretien, dans lequel en outre on associe, à chaque instruction d'entretien, un son propre au signal de déclenchement et on produit le signal de déclenchement en présence d'un motif de pré-défaut défini.

9. Dispositif (6) de traitement de données, qui est conçu pour effectuer le procédé suivant l'une des revendications 1 à 8.
